# EUROPEAN PATENT SPECIFICATION

(11) **EP 4 073 846 B1**
(45) Date of publication and mention of the grant of the patent: **24.07.2024**
(21) Application number: 19827662.8
(22) Date of filing: 11.12.2019
(51) Int. Cl.: H01L 29/16, H01M 4/04, C23C 16/26, C23C 16/505, C23C 16/54, H01L 21/02

(54) **METHOD AND APPARATUS FOR DEPOSITION OF CARBON NANOSTRUCTURES**
VERFAHREN UND VORRICHTUNG ZUR ABSCHEIDUNG VON KOHLENSTOFFNANOSTRUKTUREN
PROCÉDÉ ET APPAREIL DE DÉPÔT DE NANOSTRUCTURES DE CARBONE

(43) Date of publication of application: 19.10.2022
(73) Proprietor: Jozef Stefan Institute, 1000 Ljubljana (SI); National University Corporation Tokai National Higher Education and Research System, Nagoya-shi, Aichi-ken 464-8601 (JP)
(72) Inventor: ZAPLOTNIK, Rok, 1000 Ljubljana (SI); MOZETIC, Miran, 1000 Ljubljana (SI); PRIMC, Gregor, 1000 Ljubljana (SI); VESEL, Alenka, 1000 Ljubljana (SI); HORI, Masaru, Nagoya, 464--8603 (JP); ODA, Osamu, Nagoya, 464--8603 (JP)
(74) Representative: Mewburn Ellis LLP
(86) International application number: PCT/EP2019/084734
(87) International publication number: WO 2021/115596

(56) References cited:
- WO-A1-2017/064113
- WO-A1-2019/238206
- US-A1- 2008 206 484
- US-A1- 2009 110 627
- US-A1- 2016 133 462

## Description

### Field of the Invention

The present invention relates to methods for deposition of carbon nanostructures. These may be referred to herein as multi-layered graphene sheets (sometimes called "carbon nanowalls"). They may be referred to as graphene mesh, and/or three dimensional graphene mesh. Advantageously, embodiments of the invention enable deposition of materials of high surface to mass ratio. The deposited materials are useful in numerous applications such as radiation absorption devices, fuel cells, photovoltaic devices, super-capacitors and super-batteries.

### Background

Two dimensional graphitic materials are useful in numerous applications such as electrochemical and photoelectrical devices, microelectronics and optics. Of particular importance are graphene materials in a form of thin films of graphene sheets oriented vertically on a substrate or forming a mesh of nano-sheets. Such thin films may have the thickness of the order of a micrometre (for example). They typically consist of numerous graphene sheets each have a surface area of less than about a square micrometre and a thickness of the order of several nanometres to a few tens of nanometres. It is possible for the distance between neighbouring sheets to be in the range of a few tens of nanometres to several micrometres. The total surface area of graphene sheets within such a thin film is orders of magnitude larger than the geometrical area of a product coated with such a film.

Graphene sheets are electrically and thermally conductive and hence such thin films are highly sought in any application where a large surface to mass ratio and good electrical and thermal conductivity is beneficial, such as in catalysis, batteries and capacitors. Because such thin films represent perhaps the most efficient absorbers of light quanta, they are very desirable in photocatalysis and photovoltaics as well as for light absorbers.

Different expressions have been adopted in the art for materials of the type described above, including: carbon nanostrips, carbon nanomesh, carbon nanowalls, vertically oriented graphene sheets, multilayer graphene sheets, multilayer carbon nanowalls, etc.

The first scientific report on deposition of thin films of graphene sheets might be the paper Y. Wu et al., Carbon nanowalls grown by microwave plasma enhanced chemical vapour deposition, Adv. Mater. 14 (2002) 64-67. The authors used a gaseous precursor (methane admixed with hydrogen). Upon plasma conditions, the methane molecules dissociated to form CHₓ radicals. The radicals stuck on a surface of a suitable catalyst (nickel and iron) and accumulated there in the form of randomly oriented graphene sheets. This procedure, with appropriate alternations, has been used by numerous authors since the pioneer work by Wu et al.

Recent advances in plasma-stimulated deposition of thin films consisting of graphene sheets suitable for different applications are reviewed as follows.

Yeh and Hsu [Method and system for growth of graphene nanostripes by plasma enhanced chemical vapour deposition, US2019093227 (A1)] added dichlorobenzene to methane, hydrogen and argon to facilitate growth of carbon nanostripes. A small admixture of dichlorobenzene was found useful for deposition of thin films of carbon nanowalls, while large admixtures facilitate growth of carbon nanomesh. Ifuku et al. [Graphene structure forming method and graphene structure forming apparatus, US2019085457] used remote plasma sources to dissociate hydrocarbon precursors. A variety of embodiments were disclosed, but best results, in terms of deposition of thin films of graphene nanosheets, were observed when using ethylene as a carbon-containing precursor with argon and hydrogen as the main gases. Suitable pressures were between 1 and 600 Pa and substrate temperatures between 400 and 800 °C.

Holbner et al. [Toroidal plasma processing apparatus, EP2974558] disclosed a powerful plasma source for deposition of thin films of various carbon materials from diamond to graphene. They used the classical gas mixture (methane, argon and hydrogen) at discharge powers between about 5 and 10 kW. The type of the material grown on any substrate depended on various parameters.

There are a few reports in the literature disclosing the deposition of nano carbon using plasma created in carbon dioxide. Toyoshima used COz excited by microwave plasma to produce carbon nanotubes, carbon onions and other nano-carbons [US2015/0007773A1]. Hydrogen was used as the carrier gas. The COz molecules dissociated to O and C atoms upon plasma conditions. The O atoms interacted with hydrogen to form water vapour, while carbon was deposited on the glass wall of the microwave reactor. Best results were reported for small concentration of COz in H₂. A similar device using microwave plasma and carbon dioxide is also disclosed in WO 2016/024301A1 except that water vapour is used as a carrier gas instead of hydrogen.

CN109179388 (A) discloses a similar method to US2015/0007773A1 except that hydrogenation of the substrate is used in the first step and carbon monoxide in the next one in order to deposit a graphene sheet.

Mori et al [Synthesis of carbon nanowalls by plasma-enhanced chemical vapour deposition in a CO/H2 microwave discharge system, Diamond & Related Materials 20 (2011) 1129-1132] disclosed a relatively high growth rate of carbon nanowalls on single crystal silicon substrates. Mori et al observed that it was necessary to include about 8% H2 in the gas flow in order to form carbon nanowalls in preference to flower-like structures. The present inventors consider that high quality carbon nanowalls only grow in the disclosure of Mori et al for a relatively short amount of time (up to about 60 seconds). For longer deposition times, the coating becomes low quality, apparently including amorphous carbon, diamond crystallites, soot, and/or graphite grains.

Saito et al [Diamond synthesis from CO-H2 mixed gas plasma, Y. Saito, K. Sato, K. Gomi, H. Miyadera, J. Mater. Sci. 25 (1990) p.1246] reported growth of cauliflower-like structures using pure CO.

WO 2019/238206 A1 and WO 2017/064113 A1 represent as well close prior art.

### Summary of the Invention

The present invention has been devised in order to provide a further improved approach to the formation of carbon nanostructures on arbitrary substrates and that may have particular utility in the applications mentioned above and which may have improved properties.

In a first aspect, the present invention provides a method for depositing a layer of carbon nanostructures on a substrate, the carbon nanostructures consisting of an array of randomly oriented graphene sheets upstanding on the substrate, the method including the steps:
providing a processing chamber, the processing chamber having chamber walls, the processing chamber having a substrate location zone;
providing a substrate at the substrate location zone in the processing chamber, internal surfaces of the chamber walls facing the sample location zone;
evacuating the processing chamber;
providing a processing gas in the processing chamber at a pressure in the range 1 to 1000 Pa, the processing gas comprising carbon monoxide gas;
creating and sustaining gaseous plasma in the processing chamber for a period of at least 1 second, the gaseous plasma having a power density of at least 0.1 MW m⁻³;
heating the substrate to a temperature of more than 500 °C;
maintaining the internal surfaces of the chamber walls at a temperature below 300 °C;
growing the layer of carbon nanostructures on the substrate.

In some embodiments, the processing gas consists substantially only of CO gas. Accordingly, it is possible, and in some cases preferred, not to use any carrier gas in the method. However, it will be understood that in practical systems, the processing chamber may include some residual atmosphere, in particular water. H₂O dissociates to H, OH and O in plasma conditions. H atoms tend to associate to H₂ molecules on the surface of any material facing plasma. Therefore, in practical conditions there may be hydrogen present in the processing chamber. Preferably the amount of hydrogen present is less than 8%, more preferably not more than 7%, not more than 6%, not more than 5%, not more than 4%, not more than 3%. In terms of CO, preferably the processing gas consists of at least 95% CO (more preferably at least 96%, or at least 97%), with the remainder impurities.

In a second aspect, the present invention provides a method for depositing a layer of carbon nanostructures on a substrate, the carbon nanostructures consisting of an array of randomly oriented graphene sheets upstanding on the substrate, the method including the steps:
providing a processing chamber, the processing chamber having chamber walls, the processing chamber having a substrate location zone;
providing a substrate at the substrate location zone in the processing chamber, internal surfaces of the chamber walls facing the sample location zone;
providing a carbon-containing precursor material in condensed form at or adjacent the substrate location zone in the processing chamber;
evacuating the processing chamber;
providing a processing gas in the processing chamber at a pressure in the range 1 to 1000 Pa, the processing gas comprising oxygen and/or an oxygen-containing gas;
creating and sustaining gaseous plasma in the processing chamber for a period of at least 1 second, the gaseous plasma having a power density of at least 0.1 MW m⁻³;
heating the substrate to a temperature of more than 500 °C;
heating the carbon-containing precursor material to a temperature of more than 500 °C;
maintaining the internal surfaces of the chamber walls at a temperature below 300 °C;
growing the layer of carbon nanostructures on the substrate.

In some embodiments, the processing gas consists of one or more of: Oz, COz, CO.

In a third aspect, the present invention provides an apparatus for performing a method according to the first and/or second aspect.

In a fourth aspect, the present invention provides a layer of carbon nanostructures on a substrate, obtained by or obtainable by a method according to the first aspect or the second aspect.

The carbon nanostructures may advantageously withstand heating to moderate temperatures, such as temperatures of 500 °C or higher, for example in air. Given that the method requires that the substrate is heated to more than 500 °C, the substrate should be formed of a material capable of withstanding such temperatures in the environment of the processing chamber in use.

The methods of the present invention typically enable rapid deposition of carbon nanostructures and are scalable to large substrates.

The morphological details of materials deposited according to the methods of invention depend on particular embodiments.

Conveniently, it is possible for the methods of the present invention to be carried out without the presence of any catalyst for nucleation or growth of graphene sheets.

The layer of carbon nanostructures preferably consists of at least 80wt% randomly oriented graphene sheets upstanding on the substrate. More preferably the layer of carbon nanostructures consists of at least 85wt%, or at least 90wt%, or at least 95wt% or at least 98wt% randomly oriented graphene sheets upstanding on the substrate. It is preferred to avoid non-graphene carbon, such as amorphous carbon.

As mentioned above, the power density of the discharge used for sustaining gaseous plasma in the processing chamber is at least, and preferably higher than, 0.1 MW m⁻³ (megawatt per cubic metre). More preferably, the power density is at least 0.3 MW m⁻³. Still more preferably, the power density is at least 1 MW m⁻³. It is possible that the preferred power density varies with the variation of pressure in the processing chamber. For example, at pressure below 5 Pa, the power density is preferably at least 0.1 MW m⁻³. At pressure between 5 and 10 Pa, the power density is preferably at least 0.3 MW m⁻³. At pressure above 10 Pa, the power density is preferably at least 1 MW m⁻³.

In some embodiments, the power density divided by pressure is at least 0.1 MW m⁻³ / Pa.

As will be understood, the power density of the plasma may be measured by measuring the forward and reflected powers. The power absorbed by plasma is the forward power of the radiofrequency generator minus reflected power. Both are measurable with power meters.

In the first or second aspect, the pressure of the processing gas may be at least 3 Pa. In some embodiments, the pressure of the processing gas may be up to 100 Pa. It is considered that operating within the ranges of pressure defined in the present disclosure permits the improved rapid deposition of the layer of carbon nanostructures.

Although it is possible to heat the substrate independently (e.g. using a laser), it is preferred to allow the substrate to be heated by the plasma. This makes the process better suited for industrial scale manufacture of the coatings.

In the second aspect, the processing gas may consist of oxygen. Alternatively, in the second aspect, the processing gas may consist of carbon dioxide. Alternatively, in the second aspect, the processing gas may consist of water vapour. More generally, the processing gas may consist of one or more of oxygen, carbon dioxide, carbon monoxide, water vapour and incidental impurities (e.g. not more than 8%, more preferably not more than 7%, not more than 6%, not more than 5%, not more than 4%, or not more than 3% incidental impurities).

In the second aspect, the carbon-containing precursor material in condensed form may be a solid. Suitable solid carbon-containing precursor materials include graphite and solid polymers.

In the second aspect, the carbon-containing precursor material in condensed form may be a liquid. Suitable liquid carbon-containing precursor materials include liquid polymers and tar.

In any aspect of the invention, the substrate may be configured to move, such that the substrate moves through gaseous plasma thus enabling deposition in a continuous manner.

Other aspects of the invention relate to the production of coatings consisting of carbon nanostructures such as those described above, said method comprising the following steps: providing a heated substrate, modifying said heated substrate by any of the aspects of the invention as described above, thereby obtaining the coating.

The internal surfaces of the chamber walls may be maintained at a temperature of not more than 290 °C, not more than 280 °C, not more than 270 °C, not more than 260 °C, not more than 250 °C, not more than 240 °C, not more than 230 °C, not more than 220 °C, not more than 210 °C, not more than 200 °C, not more than 190 °C, not more than 180 °C, not more than 170 °C, not more than 160 °C, not more than 150 °C, not more than 140 °C, not more than 130 °C, not more than 120 °C, not more than 110 °C, not more than 100°C, not more than 90 °C, not more than 80 °C, not more than 70 °C, not more than 60 °C, or not more than 50 °C. Without wishing to be bound by theory, the inventors consider that the temperature of the walls of the processing chamber has an effect on the quality of the layer of carbon nanostructures grown on the substrate, in particular in terms of the content of unwanted carbon such as amorphous carbon, diamond crystallites, soot, and/or graphite grains and in terms of the thickness of the carbon nanowalls and their upright orientation.

### Summary of Figures

Embodiments illustrating the principles of the invention will now be disclosed with reference to the accompanying figures, in which:
**Figure 1** shows a scanning electron microscopy image of a layer of carbon nanostructures deposited according to Example 1.
**Figure 2** shows a scanning electron microscopy image of a layer of carbon nanostructures deposited according to Example 2.
**Figure 3** shows a scanning electron microscopy image of a layer of carbon nanostructures deposited according to Example 3.
**Figure 4** shows a schematic view of a device suitable for depositing the three-dimensional graphene mesh in a batch process according an embodiment of the first aspect.
**Figure 5** shows a schematic view of a device suitable for depositing the three-dimensional graphene mesh in a batch process according to an embodiment of the second aspect.
**Figure 6** shows a schematic view of a device suitable for depositing the three-dimensional graphene mesh in a continuous process.
**Figure 7** shows a schematic view of a device suitable for depositing the three-dimensional graphene mesh in a continuous process.

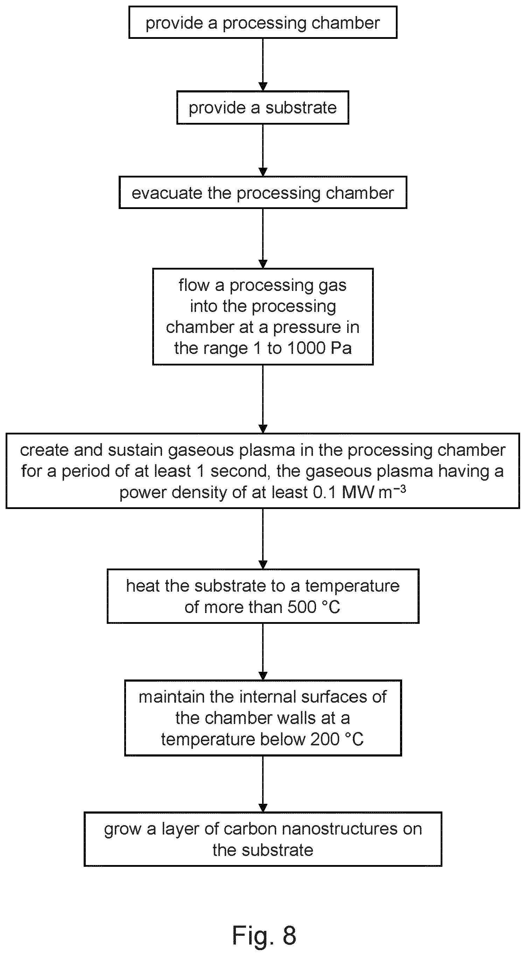

**Figure 8** shows a schematic flow diagram corresponding to an embodiment according to the first aspect.

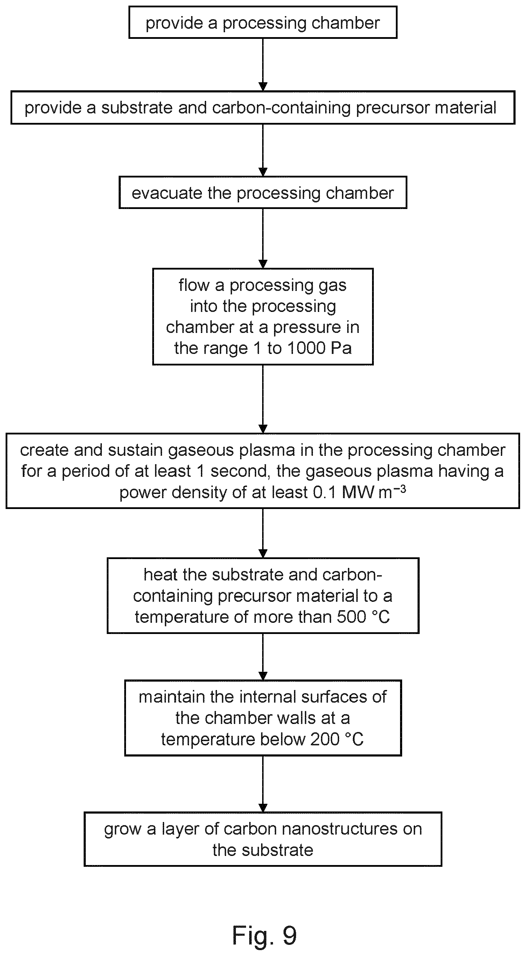

**Figure 9** shows a schematic flow diagram corresponding to an embodiment according to the second aspect.

### Detailed Description of the Invention

Aspects and embodiments of the present invention will now be discussed with reference to the accompanying figures. Further aspects and embodiments will be apparent to those skilled in the art. All documents mentioned in this text are incorporated herein by reference.

The present disclosure seeks to employ carbon monoxide (CO) as the source of carbon atoms in the growth of the layer of carbon nanostructures. Carbon monoxide is a chemical compound containing one oxygen and one carbon atom. The oxygen and carbon atoms are bonded strongly. The dissociation energy of carbon monoxide is more than 11 eV, which makes CO one of the strongest bonded molecules. Separation of atoms in the CO molecule is an extremely endothermic reaction and thus does not occur at temperatures below several 1000 °C in thermal equilibrium.

Graphite is often assumed as the common state of solid carbon. Molecular Oz is the common state of oxygen at ambient conditions. The reaction between graphite and Oz molecules is moderately exothermic, but does not occur at room temperature due to a large potential barrier. Oxidation of graphite in an oxygen-containing atmosphere to COz or CO therefore occurs only at elevated temperatures, however the oxidation probability remains low even for temperatures exceeding 1000 °C.

The potential barrier is much lower for oxidation of graphite with atomic oxygen (O). However, oxidation of graphite by O atoms has not attracted much attention since O atoms are not stable at ambient conditions.

Solid carbon (graphite), oxygen and carbon monoxide are thus stable substances and will not interact significantly at practical temperatures. In fact, CO will more likely recombine with oxygen (or many other oxygen-containing compounds) to form COz rather than dissociate to C and O atoms. The dissociation of CO to C and O atoms is therefore regarded as energetically unfavourable and chemically almost impossible because the dissociation products (C and O atoms) will associate immediately to CO molecules to on the basis of minimization of entropy. It is considered by the present inventors that this is the most probable reason why the literature does not consider in detail the application of CO as a source of C atoms for building carbon nanostructures.

Without wishing to be bound by theory, the present inventors consider that there is a possibility to use CO molecules for building carbon nanostructures, if specific conditions are assured, where the surface dissociation of CO to C and O atoms is more extensive than the association of C and O atoms to CO molecules. As explained above, such conditions are in practice not possible in thermal equilibrium. Plasma conditions at low pressure, however, allow for thermal non-equilibrium, therefore, it is theoretically possible to meet such specific conditions that favour dissociation of CO molecules to C and O atoms rather than association of C and O atoms to CO molecules. In such plasma conditions, it is considered that CO molecules partially ionize to CO⁺ ions, slow electrons are attached to form CO⁻ ions, and CO molecules are excited to various electronic, vibrational and rotational states. The thermodynamic behaviour of a CO molecule in the gas phase is therefore different to the thermodynamics of surface effects upon non-equilibrium plasma conditions.

CO molecules are excited to vibrational states by collisions with plasma electrons. If collisions are frequent, a substantial amount of CO molecules will be excited also to electronic states, of which some are known to be metastable states with a lifetime (e.g. half-life) more than a millisecond. When a CO molecule, in such a highly excited state, touches a solid material, it may undergo several types of inelastic reactions. Without wishing to be bound by theory, it is considered that at low surface temperature CO molecules of a reasonable potential energy will undergo predominantly elastic collisions; this means that they will just be reflected from the surface without losing their potential energy. At elevated surface temperatures, for example at temperatures about 200 °C, CO molecules will be quenched upon touching the surface, so that their potential energy will be lost. At even higher surface temperatures, for example at temperatures more than about 500 °C, CO molecules will dissociate to C and O atoms providing their potential energy in the gas phase is high enough. The probability for dissociation of the CO molecules on hot surfaces will increase with the surface temperature. An essential condition for dissociation of the CO molecules on a hot surface is a high potential energy of the CO molecules in the gas phase next to the substrate. For example, the CO molecules in the gas phase should have a potential energy higher than 6 eV (this is the potential energy of the first metastable state) or even more than 8 eV (the potential energy of the second electronically excited state).

A potential energy of 6 or even 8 eV is obtainable upon thermodynamic equilibrium only at very high temperatures, for example temperature more than 5000 °C. Such a high temperature is impractical because all known solid materials melt upon heating to such high temperatures.

In non-equilibrium conditions, a high potential energy of CO molecules is possible even at low gas temperature, for example below 500 °C. The non-equilibrium state of gas is obtained in a gaseous discharge where the gas is in the state of plasma. Because at least one CO molecular state of a high potential energy is metastable, it is possible to establish conditions with a large concentration of CO molecules with a potential energy higher than 6 eV. Such conditions are met at a high power density of the gaseous discharge, for example about 0.1 MW m⁻³ or higher.

CO molecules of a high potential energy are considered to be rather stable in the gas phase at low or moderate gas pressure, in a pressure range up to about 1000 Pa. At higher pressure they are thermalized (lose their potential energy) at gas-phase collisions. The upper limit of the useful range of pressures, according to the preferred implementation of the invention, is therefore at about 1000 Pa.

CO molecules of a high potential energy may or may not lose their energy at collisions with surfaces of the processing chamber. Surface effects are more pronounced at low pressure. The preferred lower limit of the useful range of pressures according to the methods of invention is therefore about 1 Pa, or more general a few Pa, such as 2, 3, 4 or 5 Pa.

The surface loss of potential energy, which CO molecules obtain upon gaseous plasma conditions, depends on the surface temperature. At low temperature the loss is not extensive, hence CO molecules may retain their potential energy even though they have suffered several collisions with the internal surface of a wall of the processing chamber. The preferred surface temperature of the processing chamber is therefore below about 200 °C. If the surface temperature is in the range between about 200 and 500 °C, CO molecules lose their potential energy and become ineffective. Accordingly, the temperature of the internal surfaces of the walls of the processing chamber therefore have their temperature controlled, by cooling, to temperatures below 200 °C, preferably below 50 °C.

A high temperature of the surface facing CO molecules of a high potential energy facilitates surface dissociation of such molecules to C and O atoms. The effect is beneficial for growing a graphene mesh (or similar structures). The surface of the substrate is therefore heated to high temperatures, preferably above 500 °C, to benefit from heat-depending surface dissociation of CO molecules of a high potential energy. As described above, other walls of the processing chamber are cooled, thus preventing loss of CO molecules of a high potential energy by surface quenching. In this way as many CO molecules as possible are used for dissociation on the substrate surface, where C atoms represent building blocks for the graphene mesh (carbon nanostructures).

Atomic oxygen, which is also a product of surface dissociation of CO molecules of a high potential energy, may associate with O atoms, which are chemisorbed on the surface of the substrate to form Oz molecules. This effect is regarded as beneficial because the interaction probability for oxidation of graphite with molecular oxygen is low at low or even moderate or elevated surface temperature. The oxidation probability (oxidation of graphite-like materials with molecular oxygen) increases with increasing surface temperature and eventually - at very high temperatures - reaches the probability of surface dissociation of CO molecules of a high potential energy. This effect is detrimental and therefore the power density should be kept high enough to ensure a large flux of CO molecules of a high potential energy onto the substrate. A power density of about 1 MW m⁻³ or higher was found beneficial for assuring a high dissociation rate of CO molecules of a high potential energy on a substrate surface even when the substrate temperature is 1000 °C.

The oxidation rate of carbon materials with oxygen from the gas phase increases with increasing temperature of any carbon material. In an embodiment of the second aspect of the invention, a piece of carbon-containing material is placed into the processing chamber and heated to elevated temperature. Such a high temperature of the carbon-containing material is beneficial because the material represents not only a sink for oxygen atoms, but a source of additional CO molecules as well. The temperature of the carbon-containing material in the second aspect is therefore preferably above 500 °C.

The growth of three-dimensional graphene mesh was observed on many substrates, including different types of glasses, metals, and on graphite, providing that the deposition conditions were controlled as discussed above. No carrier gas or any other gas except CO, COz or Oz was used in the experiments (reported below), which are provided just as examples.

The embodiments of the invention enable rapid deposition of graphene mesh of typical growth rates of more than 60 nm/s when using an embodiment of the first aspect of the invention and more than 100 nm/s when using an embodiment of the second aspect of the invention. The growth rate can be determined by imaging the deposited layer of carbon nanostructures in cross section using SEM to determine the height of the carbon nanostructures, the growth rate then being determined based on knowledge of the time of growth.

We now turn to a more detailed description of the drawings. In the drawings, similar features in different embodiments are indicated with identical reference numbers.

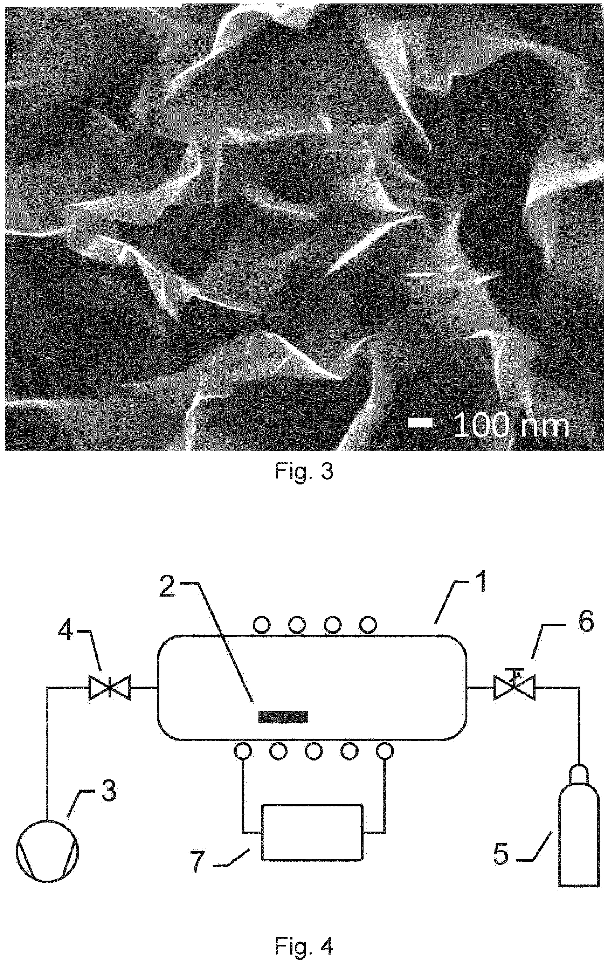

Figure 4 shows a schematic view of a device suitable for depositing the three-dimensional graphene mesh in a batch process according to an embodiment of the first aspect. The processing chamber 1 is originally at room temperature. After mounting a substrate 2 at the substrate location, the processing chamber 1 is evacuated to a pressure of about 1 Pa using a vacuum pump 3. When the pressure of 1 Pa is achieved, the vacuum pump 3 is separated from the processing chamber 1 by closing the valve 4. Carbon monoxide is then leaked into the processing chamber 1 from the container 5 through the leak valve 6 until the desired pressure (typically between 5 and 100 Pa) is achieved in the processing chamber 1. Then, plasma is ignited in the processing chamber 1 and sustained with a discharge generator 7 until the growth is accomplished (typically between 10 and 200 s, depending on the desired thickness of the graphene mesh). The processing chamber 1 and the substrate 2 are then cooled down to the temperature below 200 °C, preferably below 50 °C, until the system is ready for the next deposition. In view of the typical short time of deposition, the thermal mass of the processing chamber itself is sufficient to ensure that the temperature of the internal surfaces of the walls of the processing chamber remain below 200 °C during the deposition.

The embodiments of the present invention use inductively coupled plasma in pure H-mode. Such a plasma tends to be concentrated to a rather small volume, allowing a high power density is huge, away from end flanges of the processing chamber. The processing chamber walls are cooled at their outer surfaces using one or more jets of expanding compressed air, the expansion causing adiabatic cooling of the gas. The gas jets are directed to the processing chamber (typically a quartz tube in the embodiments) where dense plasma is formed within the RF coil.

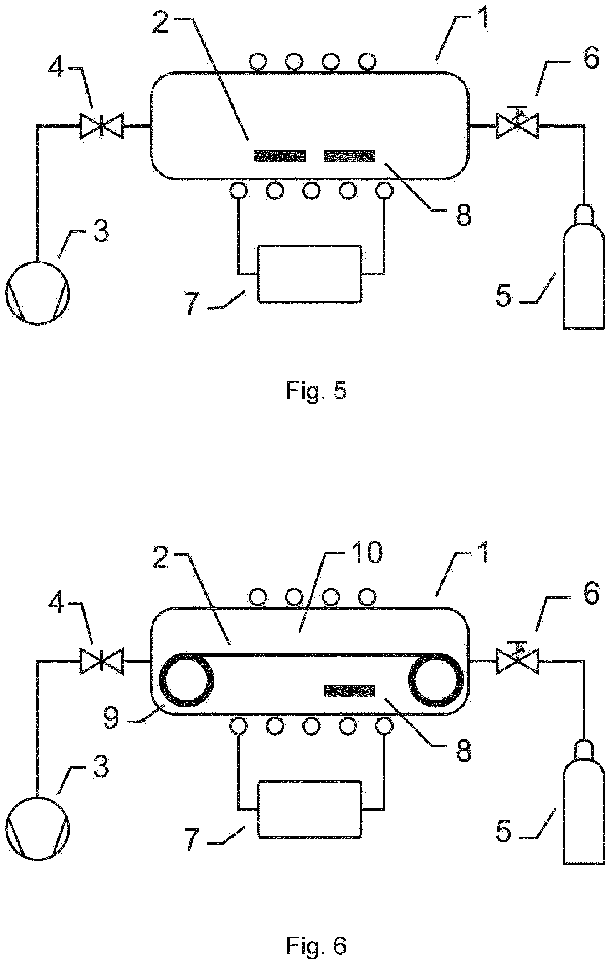

Figure 5 shows a schematic view of a device suitable for depositing the three-dimensional graphene mesh in a batch process according to an embodiment of the second aspect. The processing chamber 1 is originally at room temperature. After mounting a substrate 2 and a piece of solid carbon-containing material 8, the processing chamber 1 is evacuated to the pressure of about 1 Pa using a vacuum pump 3. Note that the solid carbon containing material can be replaced with a liquid such as a liquid carbon-containing polymer or tar. When the pressure of 1 Pa is achieved, the vacuum pump 3 is separated from the processing chamber 1 by closing the valve 4. Carbon dioxide or any gas containing oxygen is then leaked into the processing chamber 1 from the container 5 through the leak valve 6 until the desired pressure (typically between 5 and 100 Pa) is achieved in the processing chamber 1. Then, plasma is ignited in the processing chamber 1 and sustained with a discharge generator 7 until the growth is accomplished (typically between 10 and 100 s, depending on the desired thickness of the graphene mesh). The processing chamber 1, the substrate 2, and the piece of carbon-containing material 8 are then cooled down to the temperature below 200 °C, preferably below 50 °C, until the system is ready for next deposition.

Figure 6 shows a schematic view of a device suitable for depositing the three-dimensional graphene mesh in a continuous process. The processing chamber 1 is kept at temperature below 200 °C, preferably close to room temperature, at all times. If necessary, this is achieved using active cooling means. The substrate 2 is an infinite material such as a sheet moving through the processing chamber using a roll-to-roll or a similar device 9. A piece of solid carbon-containing material 8 is also located in the processing chamber 1. Note that the solid carbon containing material can be replaced with a liquid such as a liquid carbon-containing polymer or tar. The processing chamber 1 is evacuated, after mounting the substrate 2 onto the roll 9, to a pressure of about 1 Pa using a vacuum pump 3. When the pressure of 1 Pa is achieved, the vacuum pump 3 is separated from the processing chamber 1 by closing the valve 4. Gas containing oxygen (carbon dioxide in one embodiment) is then leaked into the processing chamber 1 from the container 5 through the leak valve 6 to keep the desired pressure (typically between 5 and 100 Pa) in the processing chamber 1. Plasma is sustained in the processing chamber 1 with a discharge generator 7 at all times while the substrate moves from one role to another role 9. The temperature of the substrate at the deposition zone 10 is above 500 °C.

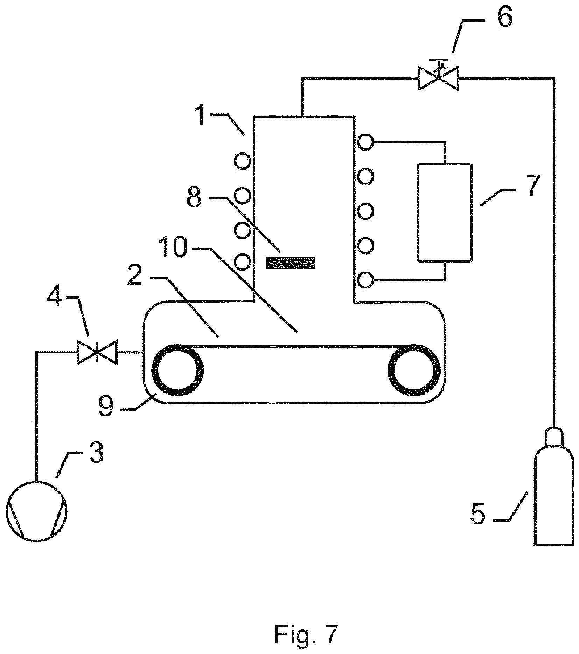

Figure 7 shows a schematic view of a further device suitable for depositing the three-dimensional graphene mesh in a continuous process. The processing chamber 1 is kept at a temperature below 200 °C, preferably close to room temperature, at all times. The substrate 2 is an infinite material such as a sheet moving through the processing chamber using a roll-to-roll or a similar device 9. A piece of solid carbon-containing material 8 is also immersed into the processing chamber 1. Note that the solid carbon containing material can be replaced with a liquid such as a liquid carbon-containing polymer or tar. The processing chamber 1 is evacuated, after mounting the substrate 2 onto the roll 9, to a pressure of about 1 Pa using a vacuum pump 3. When the pressure of 1 Pa is achieved, the vacuum pump 3 is separated from the processing chamber 1 by closing the valve 4. Gas containing oxygen (carbon dioxide in one embodiment) is then leaked into the processing chamber 1 from the container 5 through the leak valve 6 to keep the desired pressure (typically between 5 and 100 Pa) in the processing chamber 1. Plasma is sustained in the processing chamber 1 with a discharge generator 7 at all times while the substrate moves from one role to another role 9. The temperature of the substrate at the deposition zone 10 is above 500 °C. The difference between Figure 6 and 7 is in the fact that the configuration of Figure 6 enables treatment with homogeneous plasma, whereas in Figure 7 dense plasma is confined to the volume inside the coil while the substrate and/or carbon material is exposed to moderately dense plasma.

It is considered that the plasma density next to the substrate has a significant effect on the growth of the carbon nanostructures. Plasma density increases with increasing power density. At low power density, no growth is observed. H-mode is used for an inductively coupled radiofrequency discharge. This means that the plasma is concentrated within the coil. In practice, the distance between the coil and transport belt in Figure 7 should be minimal. Note that Figure 7 is schematic. In practice, the distance between the coil and the transport belt is only up to few millimetres.

In the following examples, Ti substrates were used. In other experiments, the inventors have achieved similar results using nickel, iron, silicon wafer, quartz glass, and even on graphite substrates.

### EXAMPLE 1

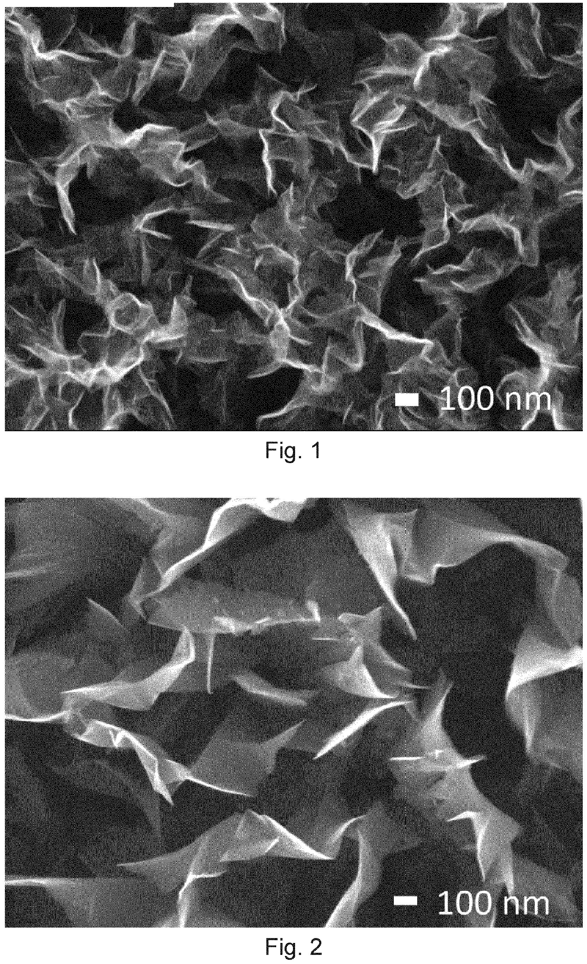

Three-dimensional graphene mesh was deposited onto a titanium substrate according to a process corresponding to an embodiment of the first aspect and using an apparatus as shown in Figure 4. The pressure upon contacting the (titanium) substrate heated to about 1000 °C with the pure carbon monoxide gas was 20 Pa, the frequency of the discharge generator was 13.56 MHz and the power density 7 MW m⁻³. The deposition time was 30 s. The three-dimensional graphene mesh deposited on the titanium substrate was imaged with a scanning electron microscope (SEM). Figure 1 represents an SEM image of a typical product.

### EXAMPLE 2

Three-dimensional graphene mesh was deposited onto titanium substrate according a process corresponding to an embodiment of the second aspect by using carbon dioxide and a piece of graphite as a solid carbon-containing precursor material, using an apparatus as shown in Figure 5. The pressure upon contacting the (titanium) substrate heated to about 1000 °C with the carbon dioxide gas was 30 Pa, the frequency of the discharge generator was 13.56 MHz and the power density 3.5 MW m⁻³. The deposition time was 25 s. The three-dimensional graphene mesh deposited on the titanium substrate was imaged with a scanning electron microscope (SEM). Figure 2 represents an SEM image of a typical product.

### EXAMPLE 3

Three-dimensional graphene mesh was deposited onto titanium substrate according to a process corresponding to an embodiment of the third aspect by using oxygen and a piece of polyethylene terephthalate as a solid carbon-containing precursor material using an apparatus as shown in Figure 5. The pressure upon contacting the (titanium) substrate heated to about 1000 °C with the oxygen gas was 30 Pa, the frequency of the discharge generator was 13.56 MHz and the power density 3.5 MW m⁻³. The deposition time was 25 s. The three-dimensional graphene mesh deposited on the titanium substrate was imaged with a scanning electron microscope (SEM). Figure 3 represents an SEM image of a typical product.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

## Claims

1. A method for depositing a layer of carbon nanostructures on a substrate (2), the carbon nanostructures consisting of an array of randomly oriented graphene sheets upstanding on the substrate (2), the method including the steps:
providing a processing chamber (1), the processing chamber (1) having chamber walls, the processing chamber (1) having a substrate location zone;
providing the substrate (2) at the substrate location zone in the processing chamber (1), internal surfaces of the chamber walls facing the substrate location zone;
evacuating the processing chamber (1);
providing a processing gas in the processing chamber (1) at a pressure in the range 1 to 1000 Pa, the processing gas (1) comprising carbon monoxide gas;
creating and sustaining gaseous plasma in the processing chamber (1) for a period of at least 1 second, the gaseous plasma having a power density of at least 0.1 MW m⁻³;
heating the substrate (2) to a temperature of more than 500 °C;
maintaining the internal surfaces of the chamber walls at a temperature below 300 °C;
growing the layer of carbon nanostructures on the substrate (2).

2. A method according to claim 1, wherein pressure of the processing gas is between 3 and 100 Pa.

3. A method according to claim 1 or claim 2, wherein the power density divided by pressure is at least 0.1 MW m⁻³ / Pa.

4. A method for depositing a layer of carbon nanostructures on a substrate (2), the carbon nanostructures consisting of an array of randomly oriented graphene sheets upstanding on the substrate (2), the method including the steps:
providing a processing chamber (1), the processing chamber (1) having chamber walls, the processing chamber (1) having a substrate location zone;
providing the substrate (2) at the substrate location zone in the processing chamber (1), internal surfaces of the chamber walls facing the substrate location zone;
providing a carbon-containing precursor material (8) in condensed form at or adjacent the substrate location zone in the processing chamber (1);
evacuating the processing chamber (1);
providing a processing gas in the processing chamber (1) at a pressure in the range 1 to 1000 Pa, the processing gas comprising oxygen and/or an oxygen-containing gas;
creating and sustaining gaseous plasma in the processing chamber (1) for a period of at least 1 second, the gaseous plasma having a power density of at least 0.1 MW m⁻³;
heating the substrate (2) to a temperature of more than 500 °C;
heating the carbon-containing precursor material (8) to a temperature of more than 500 °C;
maintaining the internal surfaces of the chamber walls at a temperature below 300 °C;
growing the layer of carbon nanostructures on the substrate (2).

5. A method according to claim 4, wherein the pressure of the processing gas is between 3 and 100 Pa.

6. A method and apparatus according to claim 4 or claim 5, wherein the power density divided by pressure is at least 0.1 MW m⁻³ / Pa.

7. A method according to any one of claims 4-6, wherein the processing gas consists of oxygen.

8. A method according to any one of claims 4-6, wherein the processing gas consists of carbon dioxide.

9. A method according to any one of claims 4-6, wherein the processing gas consists of water vapour.

10. A method according to any one of claims 4-9, wherein the carbon-containing precursor material (8) in condensed form is a solid and is graphite.

11. A method according to any one of claims 4-9, wherein the carbon-containing precursor material (8) in condensed form is a solid and is a polymer.

12. A method according to any one of claims 4-9, wherein the carbon-containing precursor material (8) in condensed form is a liquid and is a polymer or tar.

13. A method according to any one of claims 1 to 12, wherein the substrate (2) moves through gaseous plasma thus enabling deposition in a continuous manner.

## Patentansprüche

1. Verfahren zur Abscheidung einer Schicht aus Kohlenstoffnanostrukturen auf einem Substrat (2), wobei die Kohlenstoffnanostrukturen aus einer Anordnung von zufällig ausgerichteten Graphenlagen besteht, die auf dem Substrat (2) nach oben vorstehen, wobei das Verfahren die folgenden Schritte umfasst:
Bereitstellen einer Prozesskammer (1), wobei die Prozesskammer (1) Kammerwände aufweist, wobei die Prozesskammer (1) eine Substratpositionszone aufweist;
Bereitstellen des Substrats (2) in der Substratpositionszone in der Prozesskammer (1), wobei Innenflächen der Kammerwände der Substratpositionszone zugewandt sind;
Evakuieren der Prozesskammer (1);
Bereitstellen eines Prozessgases in der Prozesskammer (1) mit einem Druck im Bereich von 1 bis 1000 Pa, wobei das Prozessgas (1) Kohlenstoffmonoxidgas umfasst;
Erzeugen und Erhalten eines gasförmigen Plasmas in der Prozesskammer (1) für eine Dauer von zumindest 1 Sekunde, wobei das gasförmige Plasma eine Leistungsdichte von zumindest 0,1 MW m⁻³ aufweist;
Erhitzen des Substrats (2) auf eine Temperatur von mehr als 500 °C;
Halten der Innenflächen der Kammerwände auf einer Temperatur unter 300 °C;
Züchten der Schicht aus Kohlenstoffnanostrukturen auf dem Substrat (2).

2. Verfahren nach Anspruch 1, wobei der Druck des Prozessgases zwischen 3 und 100 Pa liegt.

3. Verfahren nach Anspruch 1 oder Anspruch 2, wobei die Leistungsdichte dividiert durch den Druck zumindest 0,1 MW m⁻³/Pa beträgt.

4. Verfahren zum Abscheiden einer Schicht aus Kohlenstoffnanostrukturen auf einem Substrat (2), wobei die Kohlenstoffnanostrukturen aus einer Anordnung von zufällig ausgerichteten Graphenlagen besteht, die auf dem Substrat (2) nach oben vorstehen, wobei das Verfahren die folgenden Schritte umfasst:
Bereitstellen einer Prozesskammer (1), wobei die Prozesskammer (1) Kammerwände aufweist, wobei die Prozesskammer (1) eine Substratpositionszone aufweist;
Bereitstellen des Substrats (2) in der Substratpositionszone in der Prozesskammer (1), wobei die Innenflächen der Kammerwände der Substratpositionszone zugewandt sind;
Bereitstellen eines kohlenstoffhältigen Vorläufermaterials (8) in kondensierter Form in oder neben der Substratpositionszone in der Prozesskammer (1);
Evakuieren der Prozesskammer (1);
Bereitstellen eines Prozessgases in der Prozesskammer (1) mit einem Druck im Bereich von 1 bis 1000 Pa, wobei das Prozessgas Sauerstoff und/oder sauersthoffhältiges Gas umfasst;
Erzeugen und Erhalten eines gasförmigen Plasmas in der Prozesskammer (1) für eine Dauer von zumindest 1 Sekunde, wobei das gasförmige Plasma eine Leistungsdichte von zumindest 0,1 MW m⁻³ aufweist;
Erhitzen des Substrats (2) auf eine Temperatur von mehr als 500 °C;
Erhitzen des kohlenstoffhältigen Vorläufermaterials (8) auf eine Temperatur von mehr als 500 °C;
Halten der Innenflächen der Kammerwände auf einer Temperatur unter 300 °C;
Züchten der Schicht aus Kohlenstoffnanostrukturen auf dem Substrat (2).

5. Verfahren nach Anspruch 4, wobei der Druck des Prozessgases zwischen 3 und 100 Pa beträgt.

6. Verfahren und Gerät nach Anspruch 4 oder Anspruch 5, wobei die Leistungsdichte dividiert durch den Druck zumindest 0,1 MW m⁻³/Pa beträgt.

7. Verfahren nach einem der Ansprüche 4 bis 6, wobei das Prozessgas aus Sauerstoff besteht.

8. Verfahren nach einem der Ansprüche 4 bis 6, wobei das Prozessgas aus Kohlendioxid besteht.

9. Verfahren nach einem der Ansprüche 4 bis 6, wobei das Prozessgas aus Wasserdampf besteht.

10. Verfahren nach einem der Ansprüche 4 bis 9, wobei das kohlenstoffhältige Vorläufermaterial (8) in kondensierter Form fest ist und Graphit ist.

11. Verfahren nach einem der Ansprüche 4 bis 9, wobei das kohlenstoffhältige Vorläufermaterial (8) in kondensierter Form fest ist und ein Polymer ist.

12. Verfahren nach einem der Ansprüche 4 bis 9, wobei das kohlenstoffhältige Vorläufermaterial (8) in kondensierter Form flüssig ist und ein Polymer oder Teer ist.

13. Verfahren nach einem der Ansprüche 1 bis 12, wobei sich das Substrat (2) durch gasförmiges Plasma bewegt und so eine Abscheidung auf kontinuierliche Weise ermöglicht.

## Revendications

1. Procédé pour déposer une couche de nanostructures de carbone sur un substrat (2), les nanostructures de carbone se composant d'un réseau de feuilles de graphène orientées de manière aléatoire dressées sur le substrat (2), le procédé comprenant les étapes consistant à :
fournir une chambre de traitement (1), la chambre de traitement (1) présentant des parois de chambre, la chambre de traitement (1) présentant une zone d'emplacement de substrat ;
fournir le substrat (2) au niveau de la zone d'emplacement de substrat dans la chambre de traitement (1), des surfaces internes des parois de chambre faisant face à la zone d'emplacement de substrat ;
évacuer la chambre de traitement (1) ;
fournir un gaz de traitement dans la chambre de traitement (1) à une pression dans la plage comprise entre 1 et 1000 Pa, le gaz de traitement (1) comprenant du monoxyde de carbone gazeux ;
créer et entretenir un plasma gazeux dans la chambre de traitement (1) pendant une période d'au moins 1 seconde, le plasma gazeux présentant une densité de puissance d'au moins 0,1 MW m⁻³ ;
chauffer le substrat (2) à une température supérieure à 500°C ;
maintenir les surfaces internes des parois de la chambre à une température inférieure à 300°C ;
faire croître la couche de nanostructures de carbone sur le substrat (2).

2. Procédé selon la revendication 1, dans lequel la pression du gaz de traitement est comprise entre 3 et 100 Pa.

3. Procédé selon la revendication 1 ou la revendication 2, dans lequel la densité de puissance divisée par la pression est d'au moins 0,1 MW m⁻³/Pa.

4. Procédé pour déposer une couche de nanostructures de carbone sur un substrat (2), les nanostructures de carbone se composant d'un réseau de feuilles de graphène orientées de manière aléatoire dressées sur le substrat (2), le procédé comprenant les étapes consistant à :
fournir une chambre de traitement (1), la chambre de traitement (1) présentant des parois de chambre, la chambre de traitement (1) présentant une zone d'emplacement de substrat ;
fournir le substrat (2) au niveau de la zone d'emplacement de substrat dans la chambre de traitement (1), des surfaces internes des parois de chambre faisant face à la zone d'emplacement de substrat ;
fournir un matériau précurseur contenant du carbone (8) sous une forme condensée au niveau ou à proximité de la zone d'emplacement de substrat dans la chambre de traitement (1) ;
évacuer la chambre de traitement (1) ;
fournir un gaz de traitement dans la chambre de traitement (1) à une pression dans la plage comprise entre 1 et 1000 Pa, le gaz de traitement comprenant de l'oxygène et/ou un gaz contenant de l'oxygène ;
créer et entretenir un plasma gazeux dans la chambre de traitement (1) pendant une période d'au moins 1 seconde, le plasma gazeux présentant une densité de puissance d'au moins 0,1 MW m⁻³ ;
chauffer le substrat (2) à une température supérieure à 500°C ;
chauffer le matériau précurseur contenant du carbone (8) à une température supérieure à 500 °C ;
maintenir les surfaces internes des parois de la chambre à une température inférieure à 300°C ;
faire croître la couche de nanostructures de carbone sur le substrat (2).

5. Procédé selon la revendication 4, dans lequel la pression du gaz de traitement est comprise entre 3 et 100 Pa.

6. Procédé et appareil selon la revendication 4 ou la revendication 5, dans lequel la densité de puissance divisée par la pression est d'au moins 0,1 MW m⁻³/Pa.

7. Procédé selon l'une quelconque des revendications 4 à 6 dans lequel le gaz de traitement est constitué d'oxygène.

8. Procédé selon l'une quelconque des revendications 4 à 6 dans lequel le gaz de traitement est constitué de dioxyde de carbone.

9. Procédé selon l'une quelconque des revendications 4 à 6 dans lequel le gaz de traitement est constitué de vapeur d'eau.

10. Procédé selon l'une quelconque des revendications 4 à 9, dans lequel le matériau précurseur contenant du carbone (8) est dans sa forme condensée un solide et est du graphite.

11. Procédé selon l'une quelconque des revendications 4 à 9, dans lequel le matériau précurseur contenant du carbone (8) est dans sa forme condensée un solide et est un polymère.

12. Procédé selon l'une quelconque des revendications 4 à 9, dans lequel le matériau précurseur contenant du carbone (8) est dans sa forme condensée un liquide et est un polymère ou du goudron.

13. Procédé selon l'une quelconque des revendications 1 à 12, dans lequel le substrat (2) se déplace à travers un plasma gazeux, en permettant ainsi un dépôt de manière continue.
